# EUROPÄISCHE PATENTSCHRIFT

(11) **EP 2 770 549 B1**
(45) Veröffentlichungstag und Bekanntmachung des Hinweises auf die Patenterteilung: **14.06.2017**
(21) Anmeldenummer: 14151238.4
(22) Anmeldetag: 15.01.2014
(51) Int. Cl.: H01L 35/32, H01L 35/34

(54) **Thermoelektrisches Modul**
Thermoelectric module
Module thermoélectrique

(30) Priorität: 20.02.2013 DE 102013202785
(43) Veröffentlichungstag der Anmeldung: 27.08.2014
(73) Patentinhaber: MAHLE Behr GmbH & Co. KG, 70469 Stuttgart (DE)
(72) Erfinder: Angermann, Hans-Heinrich, 70567 Stuttgart (DE); Fuchs, Tobias, 71034 Böblingen (DE); Himmer, Thomas, 73326 Reichenbach (DE); Schall, Volker, 71282 Hemmingen (DE)
(74) Vertreter: BRP Renaud & Partner mbB Rechtsanwälte Patentanwälte Steuerberater

(56) Entgegenhaltungen:
- DE-A1-102010 050 395
- DE-B- 1 216 955
- JP-A- H07 106 642
- US-A- 3 056 848
- US-A1- 2009 093 078
- US-A1- 2010 229 911

## Beschreibung

Die vorliegende Erfindung betrifft ein thermoelektrisches Modul mit einem fluid-dichten Gehäuse, gemäß dem Oberbegriff des Anspruchs 1. Die Erfindung betrifft außerdem ein Verfahren zur Herstellung eines derartigen thermoelektrischen Moduls.

Thermoelektrische Module werden sowohl als Heiz-Kühlelemente, beispielsweise als sogenannte Peltierelemente, als auch als thermoelektrische Generatoren genutzt. Der grundlegende Aufbau für beide Anwendungen ist dabei derselbe. Zunächst sorgt außen eine elektrisch nicht leitende Schicht, z.B. aus Keramik, für eine elektrische Isolierung. Im Inneren des thermoelektrischen Moduls befinden sich thermoelektrische aktive Elemente, die an elektrische Leiterbahnen angeschlossen sind. Als Fügematerial zwischen den Leiterbahnen und dem thermo-elektrisch aktiven Element wird häufig Lot verwendet. Die thermoelektrischen Module werden üblicherweise mit einer keramischen Seite auf der kalten Seite und mit der metallischen Seite an der heißen Seite angebunden. Um ein einfaches Schweißen des thermoelektrischen Moduls zu ermöglichen, ist es vorteilhaft, die Keramik auf einen metallischen Grundwerkstoff aufzubringen. Oft wird auf der heißen Seite des thermoelektrischen Moduls die hohe Temperatur durch ein Verbrennungsabgas erzeugt, welches noch Sauerstoff und insbesondere auch erhöhte Gehalte an Wasser enthalten, so dass diese Verbrennungsabgase stark oxidierend wirken. Das thermoelektrisch aktive Element verändert sich durch die Oxidation, wobei sich auch gasförmige, das heißt flüchtige, Oxide bilden können. Daneben führt das Abgas Kohlenwasserstoffe und Ruß mit sich, welches sich nach Kondensation bei Temperaturen unterhalb der Taupunkttemperatur als parasitäre elektrisch und wärmeleitende Schicht auf dem thermoelektrisch aktiven Element niederschlägt. Das Abgas ist somit also aus unterschiedlichsten Gründen vom thermoelektrischen aktiven Element fernzuhalten.

Neben der Gefahr der Oxidation neigen bestimmte thermoelektrisch aktive Elemente, die beispielsweise Tellur (Te) oder Antimon (Sb) enthalten, zur Element-abdampfung. Dies spielt bei den Sb-Basiswerkstoffen, wie beispielsweise CoSb₃ und Zn₄Sbₛ eine Rolle, da diese thermoelektrisch aktiven Elemente insbesondere für den Einsatz bei erhöhten Temperaturen bis zu 400° C und sogar darüber hinaus gedacht sind.

Zur Verhinderung der Oxidation sind bereits amorphe elektrische Module bekannt, die komplett in ein Gehäuse, beispielsweise aus Edelstahl, eingeschlossen sind und bei denen der Innenraum mittels eines Inertgas aufgefüllt ist. Hierdurch kann zwar die Oxidation unterbunden werden, die zuvor beschriebene Element-abdampfung jedoch nicht. Außerdem ist ein Spalt zwischen dem metallischen Gehäuse und dem Inneren vorhanden, der wiederum die Effizienz des thermoelektrischen Moduls reduziert.

Aus der US 7,461,512 B2 ist ein thermoelektrisches Modul bekannt, dessen Innenraum zwischen dem thermoelektrisch aktiven Element und einem Gehäuse mittels eines Sol-Gels ausgegossen ist. Durch thermische Umwandlung erhält man eine Ummantelung des thermoelektrisch aktiven Elements mit einem sogenannten Aerogel. Da der Porendurchmesser dieses Aerogels viel kleiner ist als die mittlere freie Weglänge des abgedampften Elements, kann die Elementabdampfung um einen Faktor 10 reduziert werden. Gegenüber einer Oxidation schützt ein derartiges Aerogel jedoch nicht.

Aus der DE 10 2011 005 246 A1 ist ein gattungsgemäßes thermoelektrisches Modul mit einem fluiddichten Gehäuse bekannt, in welchem zumindest ein thermoelektrisch aktives Element angeordnet ist. Das Gehäuse ist dabei aus zwei Gehäuseelementen zusammengesetzt, nämlich aus einem metallischen Gehäuseelement und einem weiteren Gehäuseelement, dass an derjenigen Seite des metallischen Gehäuseelements angeordnet ist, die eine keramische Schicht aufweist. Es wird somit vorgeschlagen, dass auf einem metallischen Gehäusematerial eine elektrische Isolierschicht aufgebracht wird und erst darauf die eigentlichen Leiterbahnen.

Aus der DE 10 2012 208 295 A1 ist ein thermoelektrisches Modul bekannt, das ein Gehäuseelement und ein auf dem Gehäuseelement angeordnetes thermoelektrischen Element aufweist, wobei zwischen dem thermoelektrischen Element und dem Gehäuseelement ein Fügenahtbereich vorgesehen ist, der durch ein Zusammenpressen eines Fügematerials gebildet wurde. Ferner umfasst das thermoelektrische Modul ein weiteres Gehäuseelement, das mit dem Gehäuseelement zu einem wahlweise fluiddichten Gehäuse verbunden ist, wobei in dem Gehäuse das thermoelektrische Element und der Fügenahtbereich angeordnet sind.

DE1216955B offenbart ebenfalls ein thermoelektrisches Modul mit einem fluiddichten Gehäuse.

Die vorliegende Erfindung beschäftigt sich daher mit dem Problem für ein thermoelektrisches Modul der gattungsgemäßen Art eine verbesserte Ausführungsform anzugeben, die sich insbesondere durch eine lange Lebensdauer auszeichnet. Dieses Problem wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, ein thermoelektrisches Modul mit einer zweifachen Kapselung zu versehen und zwar einer äußeren Kapselung, die im Wesentlichen durch ein fluiddichtes, insbesondere metallisches oder keramisches Gehäuse gebildet wird und einer inneren Kapselung, die durch eine das in dem fluiddichten Gehäuse angeordnete thermoelektrisch aktive Element umgebende Beschichtung gebildet wird. Durch die erfindungsgemäße zweifache Kapselung lässt sich sowohl die Gefahr der Oxidation bzw. beschichtenden Verschmutzung als auch die Gefahr der Elementabdampfung des thermoelektrisch aktiven Elements beseitigen, zumindest aber reduzieren. Von weiterem großem Vorteil dabei ist, dass durch den Einsatz der zweifachen Kapselung beide Kapselungen für sich genommen nicht zwingend gasdicht sein müssen. Die äußere Kapselung, das heißt das fluiddichte Gehäuse, kann beispielsweise zwei miteinander verbundenen Gehäuseteilen, insbesondere Platten, hergestellt sein, insbesondere auch durch zwei Platten, welche umgebogene Ränder aufweisen, über welche die beiden Platten fluiddicht miteinander gefügt werden. Das fluiddichte Fügen der beiden Gehäuseteile kann beispielsweise mittels Schweißen, insbesondere Laserschweißen, WIG-Schweißen, Punktschweißen, Lichtbogenschweißen oder Kondensatorentladungsschweißen, mittels Löten, beispielsweise Weichlöten, Hartlöten oder Hochtemperaturlöten, mittels Kleben, beispielsweise mit Silikonkleber oder anorganischem Kleber auf Natursilikatbasis oder mittels Bördeln erfolgen. Während die Schweiß-, Löt- und Klebeverfahren den kompletten fluiddichten Abschluss ermöglichen, verbleibt beim Bördeln ein geringer Diffusionsspalt, der jedoch in der Art einer Labyrinthdichtung für außen vorhandene oxidative Gase wirkt.

Zweckmäßig ist zwischen den beiden Gehäuseteilen ein Rahmen angeordnet, der einen Teil des Gehäuses bildet und der fluiddicht mit den Gehäuseteilen verbunden ist. Der Rahmen kann dabei insbesondere zweiteilig ausgebildet sein, wobei ein erster Rahmenteil an dem einen Gehäuseteil und ein zweiter Rahmenteil an dem zweiten Gehäuseteile fluiddicht angeschlossen ist und wobei die Stoßstellen der beiden Rahmenteile ebenfalls fluiddicht miteinander gefügt werden. Der Rahmen besteht somit aus zwei Hälften, die bei der Montage des erfindungsgemäßen thermoelektrischen Moduls zusammengeschoben werden. Dieser Rahmen kann insbesondere zumindest teilweise aus Metall, insbesondere aus ferritischem Edelstahl wie beispielsweise 1.4512, aus einem Halbleitermaterial oder aus einem keramischen Element ausgebildet sein. Vorstellbar sind hierbei selbstverständlich unterschiedlichste Rahmenkonstruktionen.

In Bezug auf die zweite Kapselung, das heißt die Beschichtung des thermoelektrisch aktiven Elements, besteht dieses zumindest teilweise aus einem metallischen und/oder keramischen Element, aus Glas oder aus Kunststoff. Auch die Beschichtung muss aufgrund des Vorhandenseins der äußeren Kapselung nicht mehr vollständig fehlerfrei sein, insbesondere im Betrieb vollständig rissfrei bleiben, da das Eindringen von Sauerstoff und/oder Wasser unterbunden oder zumindest stark reduziert ist. Somit ist auch eine geringe Fehlertoleranz möglich, da auch eine fehlerbehaftete Beschichtung die Elementabdampfung und auch die Oxidation durch eventuell zwischen der äußeren und inneren Kapselung vorhandene oxidative Gase zum Großteil verhindert. Als Beschichtung sind insbesondere Materialien bevorzugt, die sowohl nur einen geringen parasitären elektrischen Strom als auch einen lediglich geringen parasitären Wärmestrom erlauben. Hierfür sind besonders nichtmetallische Beschichtungen besonders geeignet, z.B. eine Verglasung, eine amorpher verglasartiger Festkörper auf der Basis von Silizium, Sauerstoff und Kohlenstoff oder das Aufbringen einer Silikonharz-, Siloxan- oder einer Siloxanbasis-Beschichtung, die Pigmente oder Füllstoffe, wie beispielsweise Al₂O₃ enthält. Ebenfalls besonders bevorzugt sind solche Beschichtungen, die kovalente chemische Bindungen mit der Oberfläche des thermoelektrisch aktiven Elements herstellen können. Hierdurch kann ein mikroskopischer bzw. im Atombereich liegender Spalt zwischen der Beschichtung und dem thermoelektrisch aktiven Element vermieden werden, der für abdampfende Elemente einen Weg darstellen könnte, um sich zwischen dem thermoelektrisch aktiven Element und der Beschichtung auszubreiten und durch Fehlstellen der Beschichtung nach außen abzudampfen. Selbstverständlich ist auch weiterhin eine innere Kapselung des thermoelektrisch aktiven Elements durch vollständiges oder partielles Auffüllen des Raums zwischen Beschichtung und Gehäuse mit einem porenbehafteten Material, wie beispielsweise einem Aerogel durch einen Inertgas denkbar.

Die vorliegende Erfindung beruht weiter auf dem allgemeinen Gedanken, bei einem Verfahren zur Herstellung des erfindungsgemäßen thermoelektrischen Moduls die eigentliche Beschichtung des thermoelektrisch aktiven Elements, das heißt die innere Kapselung, erst nach der Montage des thermoelektrischen aktiven Elements im Gehäuse vorzunehmen. Hierdurch kann erreicht werden, dass ein Beschichten den Fügeprozess, das heißt die Montage des thermoelektrisch aktiven Elements im Gehäuse, nicht beeinträchtigt.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ein bevorzugtes Ausführungsbeispiel der Erfindung ist in den Zeichnungen dargestellt und wird in der nachfolgenden Beschreibung näher erläutert.

Es zeigen, jeweils schematisch:
- Fig. 1: eine Darstellung eines Ausschnitts eines erfindungsgemäßen thermoelektrischen Moduls,
- Fig. 2 bis 12: unterschiedlichste Ausführungsformen des erfindungsgemäßen thermoelektrischen Moduls mit zweifacher Kapselung.

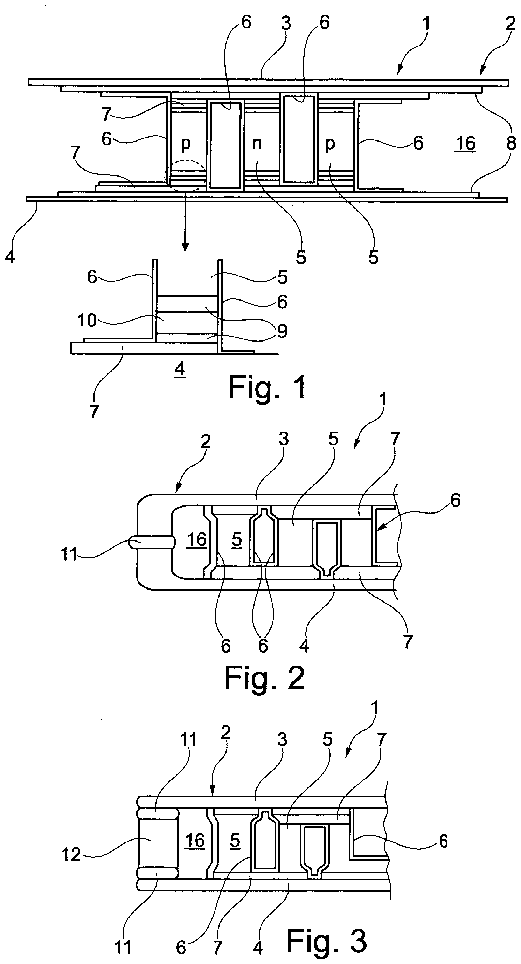

Entsprechend den Fig. 1 bis 12, weist ein erfindungsgemäßes thermoelektrisches Modul 1 ein fluiddichtes Gehäuse 2 auf, welches aus zumindest zwei fluiddicht miteinander verbundenen Gehäuseteilen 3, 4, insbesondere Platten, besteht. Innerhalb des Gehäuses 2 ist ein thermoelektrisch aktives Element 5 angeordnet, welches zur Umwandlung thermischer Energie in elektrische Energie ausgebildet ist und demzufolge als Thermogenerator funktionieren kann. Bei einer Bestromung wäre rein theoretisch auch denkbar, das thermoelektrisch aktive Element 5 zur Kühlung bzw. zur Beheizung zu verwenden. Um nun eine Oxidation des thermoelektrisch aktiven Elements 5 sowie eine Elementabdampfung von diesem wirkungsvoll verhindern zu können, ist das thermoelektrisch aktive Element 5 beschichtet, das heißt mit einer Beschichtung 6 versehen, so dass das Gehäuse 2 eine äußere Kapselung und die Beschichtung 6 eine innere Kapselung bilden. Das erfindungsgemäße Vorsehen zweier Kapselungen bietet dabei den großen Vorteil, dass jede Kapselung für sich genommen nicht 100 % dicht sein muss, wodurch zumindest geringfügige Fehler bzw. Fertigungstoleranzen kompensiert werden können.

Betrachtet man die Fig. 1, so kann man erkennen, dass das thermoelektrisch aktive Element 5 über Leiterbahnen 7 an einer elektrischen Isolierung 8 angeordnet und über diese mit dem jeweiligen Gehäuseteil 3, 4 verbunden ist. Zwischen dem thermoelektrisch aktiven Element 5 und der Leiterbahn 7 können noch weitere Schichten vorgesehen sein, wie beispielsweise eine Diffusionsbarriere bzw. Haftschicht 9 sowie ein Fügematerial 10.

Die beiden Gehäuseteile 3, 4 können beispielsweise mittels Schweißen, insbesondere mittels Laserschweißen, WIG-Schweißen, Punktschweißen, Lichtbogenschweißen oder Kondensatorentladungsschweißen, mittels Löten, Weichlöten, Hartlöten oder Hochtemperaturlöten, mittels Kleben, beispielsweise mit Silikonkleber oder anorganischem Kleber auf Natursilikatbasis, oder mittels Bördeln miteinander verbunden werden. In den Fig. 2 bis 12 ist dabei eine Fügenaht 11, insbesondere eine Schweiß-, Klebe- oder Lötnaht eingezeichnet. Beim Bördeln der beiden Gehäuseteile 3, 4 miteinander besteht zwar ein noch geringer Spalt zwischen den beiden Gehäuseteilen 3, 4, dieser jedoch aufgrund der Labyrinthdichtungswirkung vernachlässigbar.

Gemäß einer bevorzugten Ausführungsform der erfindungsgemäßen Lösung kann zwischen den beiden Gehäuseteilen 3, 4 auch ein Rahmen 12 (vgl. Fig. 3, 4, 8 sowie 11 und 12) angeordnet sein, der einen Teil des Gehäuses 2 und damit der äußeren Kapselung bildet und der zugleich fluiddicht mit den Gehäuseteilen 3, 4 des Gehäuses 2 verbunden, insbesondere verklebt, verschweißt oder verlötet ist. Allen gezeigten Varianten des erfindungsgemäßen thermoelektrischen Moduls 1 ist dabei gemein, dass das thermoelektrisch aktive Element 5 sowohl durch die äußere Kapselung, gebildet durch das Gehäuse 2, als auch durch die innere Kapselung, gebildet durch die Beschichtung 6, vor einem direkten Kontakt mit schädigenden Motorabgasen geschützt ist. Durch die doppelte Kapselung kann die Lebensdauer des erfindungsgemäßen thermoelektrischen Moduls 1 deutlich verlängert werden.

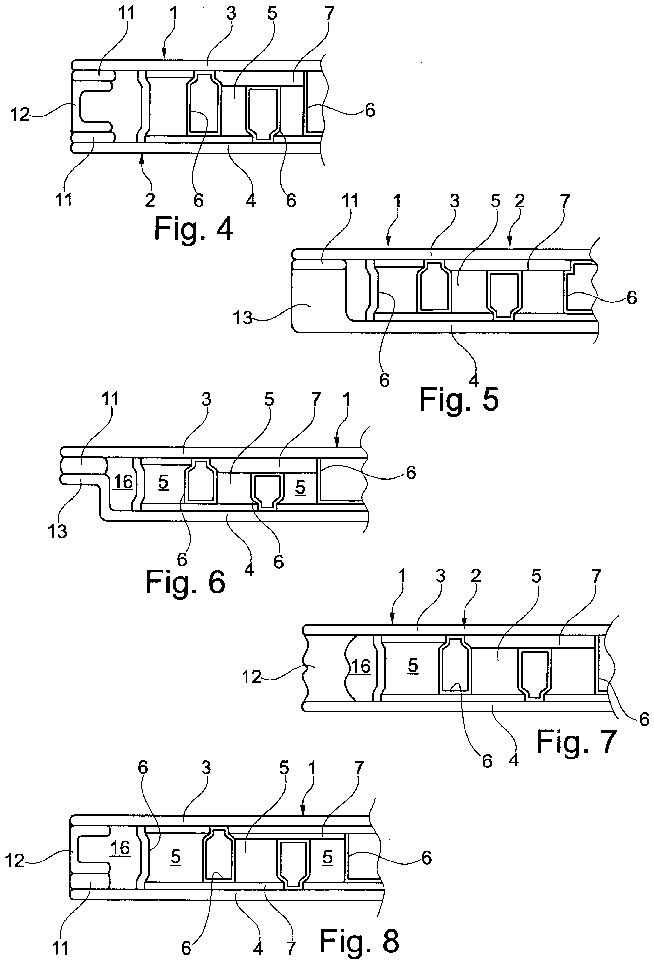

Betrachtet man die Fig. 4, so kann man erkennen, dass der Rahmen 12 beispielsweise in der Art eines C-Profils ausgebildet ist oder aber dass eines der beiden Gehäuseteile 3, 4, gemäß der Fig. 5 das Gehäuseteil 4, einen umgebogenen Rand 13 aufweist, der über die Fügenaht 11 mit dem anderen Gehäuseteil 3 verbunden ist. Einen derartig umgebogenen jedoch anders abgewinkelten Rand 13 besitzt auch das Gehäuseteil 4 nach Fig. 6. In Fig. 7 ist die Fügenaht 11 vergleichsweise dick, so dass in diesem Fall die beiden Gehäuseteile 3, 4 plan ausgebildete und parallel zueinander angeordnet sind. Bei dem thermoelektrischen Modul 1 gemäß der Fig. 8 ist der C-förmige Rahmen 12 direkt mit dem Gehäuseteil 3 verbunden und indirekt über die Fügenaht 11 mit dem Gehäuseteil 4.

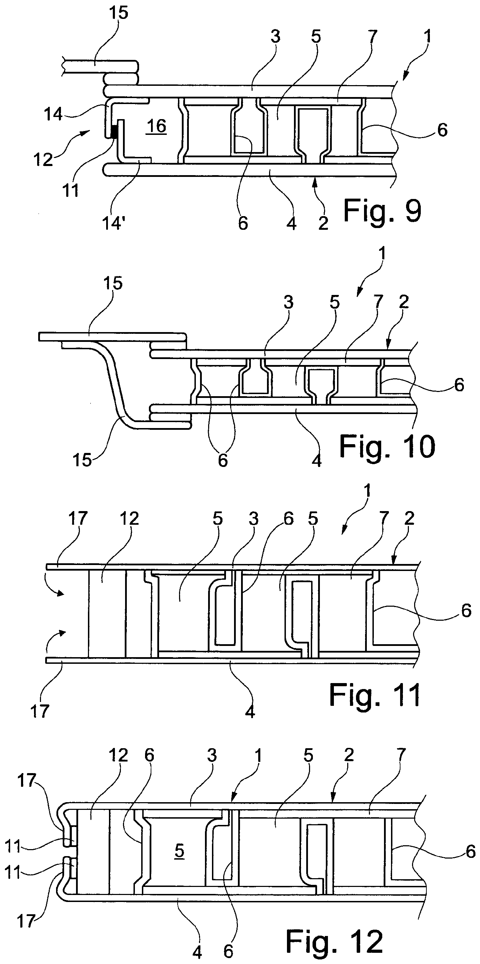

Bei dem thermoelektrischen Modul 1 gemäß der Fig. 9 weist der Rahmen 12 zwei Rahmenteile 14,14' in der Art von Winkelprofile 14 auf, die an dem jeweils zugehörigen Gehäuseteil 3, 4 angeordnet sind, wobei die beiden Rahmenteile 14, 14' fluiddicht über die Fügenaht 11 miteinander verbunden sind. Gemäß der Fig. 9 wird der Rahmen 12 aus den beiden Winkelprofilen 14,14' gebildet, so dass in diesem Fall der Rahmen 12 zweiteilig ausgebildet ist und wobei die Stoßstellen der beiden Rahmenteile 14, 14' ebenfalls fluiddicht über eine entsprechende Fügenaht 11 miteinander gefügt sind. Der Rahmen 12 kann zumindest teilweise aus Metall, insbesondere aus ferritischem Edelstahl, aus einem Haltleitermaterial oder aber aus Keramik ausgebildet sein.

Fig. 10 zeigt ein Einbindung des erfindungsgemäßen thermoelektrischen Moduls 1 in eine Halterung 15, wobei das thermoelektrische Modul 1 über diese Halterung 15 in einen nicht gezeigten Wärmetauscher einbaubar ist, so dass das thermoelektrische Modul 1 zur Kühlung beispielsweise eines Kühlmittels durch elektrische Energieentzug herangezogen werden kann. Die Fig. 11 und 12 zeigen noch das Verbinden der beiden Gehäuseteile 3, 4 mit dem Rahmen 12, wobei überstehende Endbereiche 17 der Gehäuseteile 3, 4 gemäß der Fig. 11 umgebogen und anschließend über eine Fügenaht 11 mit dem Rahmen 12 verbunden werden.

Die Beschichtung 6 besteht zumindest teilweise aus einem metallischen und/oder keramischen Material, aus Glas oder aus Kunststoff, wobei die Beschichtung 6 insbesondere aus einem amorphen, glasartigen Festkörper aus Basis von Silizium, Sauerstoff und Kohlenstoff, aus einem Silikonharz, einem Siloxan oder einer Siloxanbasis mit Pigmenten und Füllstoffen, wie beispielsweise Al₂O₃, besteht. Darüber hinaus ist die Beschichtung 6 besonders bevorzugt über kovalente chemische Bindungen mit dem thermoelektrischen aktiven Element 5 verbunden. Um insbesondere das Oxidationsrisiko weiter minimieren zu können, kann ein Raum 16 zwischen der Beschichtung 6 und dem Gehäuse 2 zumindest teilweise verfüllt, insbesondere mit einem Aerogel oder einem Inertgas, aufgefüllt sein. Ein derartiges Aerogel bzw. Inertgas verhindert oder reduziert zumindest die Oxidation.

Um die Beschichtung 6 möglichst fehlerfrei aufbringen zu können und insbesondere auch eine Fügeprozess nicht negativ zu beeinflussen, wird die Beschichtung 6 vorzugsweise erst dann aufgebracht, wenn das thermoelektrische aktive Element 5 bereits mit dem Gehäuse 2 verbunden ist. In diesem Fall bedeckt die Beschichtung 6 auch die freibleibenden Stellen der leiterbahnen 7 (vgl. Fig. 2 bis 8), wobei auch denkbar ist, dass die thermoelektrisch aktiven Elemente 5 vor dem Einbau in das Gehäuse 2 beschichtet werden (vgl. Fig. 9 bis 12), so dass in diesen Fällen die Leiterbahnen 7 teilweise freibleiben.

Mit dem erfindungsgemäßen thermoelektrischen Modul 1 ist es somit möglich, Motorabgase wirkungsvoll vom thermoelektrisch aktiven Element 5 fernzuhalten und dadurch sowohl das Risiko einer Oxidation als auch das Risiko einer Elementabdampfung deutlich zu reduzieren. Durch die Reduzierung der genannten Risiken kann die Lebensdauer des erfindungsgemäßen thermoelektrischen Moduls 1 gesteigert werden.

## Patentansprüche

1. Thermoelektrisches Modul (1) mit einem fluiddichten Gehäuse (2), in welchem zumindest ein thermoelektrisch aktives Element (5) angeordnet ist, wobei das thermoelektrisch aktive Element (5) beschichtet ist, so dass das Gehäuse (2) eine äußere Kapselung und die Beschichtung (6) eine innere Kapselung für das Element (5) bilden,
**dadurch gekennzeichnet,**
**dass** die Beschichtung (6) zumindest teilweise aus einem metallischen und/oder keramischen Material, aus Glas oder aus Kunststoff besteht.

2. Thermoelektrisches Modul nach Anspruch 1,
**dadurch gekennzeichnet,**
**dass** das Gehäuse (2) zwei miteinander verbundene Gehäuseteile (3,4) insbesondere Platten, aufweist.

3. Thermoelektrisches Modul nach Anspruch 2,
**dadurch gekennzeichnet,**
**dass** die beiden Gehäuseteile (3,4) mittels Schweißen, beispielsweise Laserschweißen, WIG-Schweißen, Punktschweißen, Lichtbogenschweißen oder Kondensatorentladungsschweißen, mittels Löten, beispielsweise Weichlöten, Hartlöten oder Hochtemperaturlöten, mittels Kleben, beispielsweise mit Silikonkleber oder anorganischem Kleber auf Natursilikatbasis, oder mittels Bördeln miteinander verbunden sind.

4. Thermoelektrisches Modul nach Anspruch 2 oder 3,
**dadurch gekennzeichnet,**
**dass** zwischen den beiden Gehäuseteilen (3,4) ein Rahmen (12) angeordnet ist, der einen Teil des Gehäuses (2) bildet und der fluiddicht mit den Gehäuseteilen (3,4) verbunden ist.

5. Thermoelektrisches Modul nach Anspruch 4,
**dadurch gekennzeichnet,**
**dass** der Rahmen (12) zweiteilig ausgebildet ist, wobei ein erster Rahmenteil (14) an dem einen Gehäuseteil (3) und ein zweiter Rahmenteil (14') an dem zweiten Gehäuseteil (4) fluiddicht angeschlossen ist und wobei die Stoßstellen der beiden Rahmenteile (14,14') ebenfalls fluiddicht miteinander gefügt sind.

6. Thermoelektrisches Modul nach Anspruch 4 oder 5,
**dadurch gekennzeichnet,**
**dass** der Rahmen (12) zumindest teilweise aus Metall, insbesondere aus ferritischem Edelstahl, aus einem Halbleitermaterial oder aus Keramik ausgebildet ist.

7. Thermoelektrisches Modul nach einem der Ansprüche 1 bis 6,
**dadurch gekennzeichnet,**
**dass** die Beschichtung (6) aus einem amorphen glasartigen Festkörper auf Basis von Si, O, C, besteht aus einem Silikonharz, einem Siloxan oder einer Siloxanbasis mit Pigmenten oder Füllstoffen wie Al₂O₃.

8. Thermoelektrisches Modul nach einem der vorhergehenden Ansprüche,
**dadurch gekennzeichnet,**
**dass** die Beschichtung (6) über kovalente chemische Bindungen mit dem thermoelektrisch aktiven Element (5) verbunden ist.

9. Thermoelektrisches Modul nach einem der vorhergehenden Ansprüche,
**dadurch gekennzeichnet,**
**dass** ein Raum (16) zwischen der Beschichtung (6) und dem Gehäuse (2) zumindest teilweise verfüllt, insbesondere mit einem Aerogel oder einem Inertgas ausgefüllt, ist.

10. Verfahren zur Herstellung eines thermoelektrischen Moduls (1) nach einem der vorhergehenden Ansprüche, bei dem die Beschichtung (6) erst nach der Montage des thermoelektrisch aktiven Elements (5) im Gehäuse (2) erfolgt.

## Claims

1. Thermoelectric module (1) with a fluid-tight housing (2) having at least one thermoelectrically active element (5) arranged therein, wherein the thermoelectrically active element (5) has a coating such that the housing (2) forms an outer encapsulation and the coating (6) forms an inner encapsulation for the element (5),
**characterized in that**
the coating (6) consists at least in part of a metallic and/or ceramic material, glass or plastic.

2. Thermoelectric module according to claim 1,
**characterized in that**
the housing (2) comprises two housing parts (3, 4) connected to one another, in particular plates.

3. Thermoelectric module according to claim 2,
**characterized in that**
the two housing parts (3, 4) are connected to one another via welding, for example laser welding, WIG welding, spot welding, arc welding, capacitor discharge welding, via soldering, for example soft soldering, hard soldering or high temperature soldering, via bonding, for example silicone adhesive bonding or inorganic adhesive bonding based on natural silicate, or via flanging.

4. Thermoelectric module according to claim 2 or 3,
**characterized in that**
a frame (12) is arranged between the two housing parts (3, 4) forming part of the housing (2) and connected to the two housing parts (3, 4) in a fluid-tight manner.

5. Thermoelectric module according to claim 4,
**characterized in that**
the frame (12) includes two parts, wherein a first frame part (14) is connected in a fluid-tight manner to the one housing part (3) and a second frame part (14') is connected in a fluid-tight manner to the second housing part (4), and wherein the butting locations of the two frame parts (14, 14') are also joined in a fluid-tight manner.

6. Thermoelectric module according to claim 4 or 5,
**characterized in that**
the frame (12) is formed at least in part of metal, in particular ferritic stainless steel, a semiconductor material or ceramic.

7. Thermoelectric module according to any of claims 1 to 6,
**characterized in that**
the coating (6) consists of an amorphous glass-like solid based on Si, O, C, of a silicone resin, a siloxane, or a siloxane base with pigments or fillers like Al₂O₃.

8. Thermoelectric module according to any of the preceding claims,
**characterized in that**
the coating (6) is bonded via covalent chemical bonds to the thermoelectrically active element (5).

9. Thermoelectric module according to any of the preceding claims,
**characterized in that**
a space (16) between the coating (6) and the housing (2) is at least in part filled, in particular filled with an aerogel or an inert gas.

10. Method for producing a thermoelectric module (1) according to any of the preceding claims, wherein applying the coating (6) takes place after mounting the thermoelectrically active element (5) in the housing (2).

## Revendications

1. Module thermoélectrique (1) avec un boîtier (2) étanche aux fluides, dans lequel est disposé au moins un élément (5) thermoélectriquement actif, dans lequel l'élément (5) thermoélectriquement actif est doté d'un revêtement de sorte que le boîtier (2) forme un encapsulage extérieur et le revêtement (6), un encapsulage intérieur pour l'élément (5),
**caractérisé en ce**
**que** le revêtement (6) est constitué au moins en partie d'un matériau métallique et/ou céramique, de verre ou de plastique.

2. Module thermoélectrique selon la revendication 1,
**caractérisé en ce**
**que** le boîtier (2) présente deux parties de boîtier (3, 4) reliées l'une à l'autre, en particulier des plaques.

3. Module thermoélectrique selon la revendication 2,
**caractérisé en ce**
**que** les deux parties de boîtier (3, 4) sont reliées l'une à l'autre au moyen d'un soudage, par exemple d'un soudage au laser, d'un soudage TIG, d'un soudage par points, d'un soudage à l'arc électrique ou d'un soudage par décharge de condensateur, au moyen d'un brasage, par exemple d'un brasage tendre, d'un brasage dur ou d'un brasage à températures élevées, au moyen de collage, par exemple avec de la colle silicone ou de la colle inorganique à base de silicate naturel, ou au moyen d'un bordage.

4. Module thermoélectrique selon la revendication 2 ou 3,
**caractérisé en ce**
**qu'**est disposé, entre les deux parties de boîtier (3, 4), un cadre (12), qui forme une partie du boîtier (2) et qui est relié de manière étanche aux fluides aux parties de boîtier (3, 4).

5. Module thermoélectrique selon la revendication 4,
**caractérisé en ce**
**que** le cadre (12) est réalisé en deux parties, dans lequel une première partie de cadre (14) est raccordée à une partie de boîtier (3) et une seconde partie de cadre (14') est raccordée à la seconde partie de boîtier (4) de manière étanche aux fluides et dans lequel les points d'aboutement des deux parties de cadre (14, 14') sont assemblés entre eux également de manière étanche aux fluides.

6. Module thermoélectrique selon la revendication 4 ou 5,
**caractérisé en ce**
**que** le cadre (12) est réalisé au moins en partie à partir de métal, en particulier à partir d'un acier inoxydable ferritique, à partir d'un matériau semi-conducteur ou à partir de céramique.

7. Module thermoélectrique selon l'une des revendications 1 à 6,
**caractérisé en ce**
**que** le revêtement (6) composé d'un corps solide de type vitreux amorphe à base de Si, 0, C est constitué d'une résine de silicone, d'un siloxane ou d'une base de siloxane avec des pigments ou des charges telles que Al₂O₃.

8. Module thermoélectrique selon l'une des revendications précédentes,
**caractérisé en ce**
**que** le revêtement (6) est relié par l'intermédiaire de liaisons chimiques covalentes à l'élément (5) thermoélectriquement actif.

9. Module thermoélectrique selon l'une des revendications précédentes,
**caractérisé en ce**
**qu'**un espace (16) entre le revêtement (6) et le boîtier (2) est rempli au moins en partie, en particulier d'un aérogel ou d'un gaz inerte.

10. Procédé servant à fabriquer un module thermoélectrique (1) selon l'une des revendications précédentes, où le revêtement (6) a lieu seulement après le montage de l'élément (5) thermoélectriquement actif dans le boîtier (2).
